# EUROPEAN PATENT SPECIFICATION

(11) **EP 1 468 041 B1**
(45) Date of publication and mention of the grant of the patent: **30.05.2007**
(21) Application number: 02804181.2
(22) Date of filing: 20.11.2002
(51) Int. Cl.: C08J 3/12, B32B 27/26, C08F 291/02

(54) **RESIN COMPOSITION**
HARZZUSAMMENSETZUNG
COMPOSITION DE RESINE

(30) Priority: 06.12.2001 CH 223001
(43) Date of publication of application: 20.10.2004
(73) Proprietor: Huntsman Advanced Materials (Switzerland) GmbH, 4057 Basel (CH)
(72) Inventor: SALVIN, Roger, Pierre-Elie, F-68300 Saint Louis (FR); HOSHINO, Masato, Tokyo 192-0904 (JP); MARCHESINI, Alessandro, F-68128 Rosenau (FR)
(74) Representative: Hoffmann, Daniele
(86) International application number: PCT/EP2002/012970
(87) International publication number: WO 2003/048234

(56) References cited:
- EP-A- 0 565 425
- EP-A- 0 662 501
- WO-A-98/05694
- US-A- 4 977 220
- US-A- 5 051 469
- US-A- 5 360 836

## Description

The invention relates to a resin composition and printed circuits comprising an optionally photostructured layer produced from this resin composition.

In the production of printed circuits, a protective film is applied to a printed circuit board in order to protect the electrical circuit and to prevent adhesion of solder material in undesired areas when electrical parts are being soldered onto the printed circuit board. The great demand for increasingly light circuit boards and the wish for a high density of circuits mean that the compositions have to have very good adhesion properties, chemical stabilities and good electrical properties.

Conventional heat-curable and photopolymerizable compositions frequently comprise an epoxy compound and a photosensitive prepolymer. If such a composition is developed in an alkaline solution after drying and exposure, the unexposed parts of the photosensitive prepolymer are more poorly soluble owing to the presence of the epoxy compound. Moreover, the epoxy compound frequently reacts with the epoxide curing agent as early as during the drying step, which slows down the development and leads to a poorly developable layer on the copper surface.

US-A-4,438,189 describes a composition comprising a compound which comprises at least two terminal ethylenically unsaturated groups, a curing agent, a photocurable prepolymer and a compound which is heat-curable.

EP 0 323 563 describes a resin composition comprising photosensitive prepolymer, a photoinitiator, a photopolymerizable vinyl monomer and/or a solvent and a finely pulverulent epoxy compound.

WO 94/03545 describes a composition as a coating material for metal and wood surfaces, comprising a curing agent having a free carboxylic acid, a compound having a β-hydroxyalkylamido group and a polyester resin.

WO 98/05694 describes oligo- or polydienes from isobutene, butadiene or isoprene, which are end-capped at one end with an unsaturated monocarboxylic acid moiety and which are used as a component for the preparation of emulsion and graft polymers. Said emulsion polymers are used as one component in thermoplastic moulding materials.

### Resin composition

The invention relates to a resin composition and printed circuits comprising an optionally photostructured layer produced from this resin composition.

In the production of printed circuits, a protective film is applied to a printed circuit board in order to protect the electrical circuit and to prevent adhesion of solder material in undesired areas when electrical parts are being soldered onto the printed circuit board. The great demand for increasingly light circuit boards and the wish for a high density of circuits mean that the compositions have to have very good adhesion properties, chemical stabilities and good electrical properties.

Conventional heat-curable and photopolymerizable compositions frequently comprise an epoxy compound and a photosensitive prepolymer. If such a composition is developed in an alkaline solution after drying and exposure, the unexposed parts of the photosensitive prepolymer are more poorly soluble owing to the presence of the epoxy compound. Moreover, the epoxy compound frequently reacts with the epoxide curing agent as early as during the drying step, which slows down the development and leads to a poorly developable layer on the copper surface.

US-A-4,438,189 describes a composition comprising a compound which comprises at least two terminal ethylenically unsaturated groups, a curing agent, a photocurable prepolymer and a compound which is heat-curable.

EP 0 323 563 describes a resin composition comprising photosensitive prepolymer, a photoinitiator, a photopolymerizable vinyl monomer and/or a solvent and a finely pulverulent epoxy compound.

WO 94/03545 describes a composition as a coating material for metal and wood surfaces, comprising a curing agent having a free carboxylic acid, a compound having a β-hydroxyalkylamido group and a polyester resin.

It has now surprisingly been found that outstanding curing and hence also excellent resistance to solvents can be achieved and crosslinking during drying can be substantially avoided if a thermally crosslinkable prepolymer compriseing acid groups is mixed with N-hydroxyalkyl-substituted carboxamides. Surprisingly, it was found that such a composition crosslinks extremely well at temperatures above 150°C and thus forms layers which are resistant to solvents.

The invention relates to a composition having the features of claim 1. Further advantageous embodiments of the invention are evident from the dependent claims and the description.

The composition comprises a compound of the formula (1), 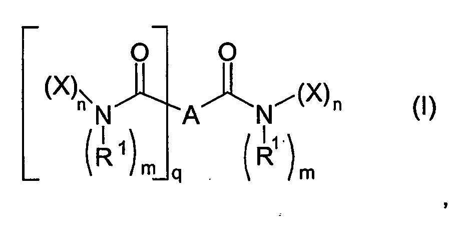 in which
A is a mono- to tetravalent, saturated or unsaturated alkyl group having 1 to 60, preferably 1 to 20 and in particular 2 to 10 carbon atoms, such as, for example, ethyl, methyl, propyl, butyl, pentyl, hexyl, heptyl, octyl, nonyl, decyl, eicosyl, tricontyl, tetracontyl, pentacontyl or hexacontyl, a mono- to tetravalent aryl group, such as, for example, phenyl or naphthyl, a mono- or dialkylamino group having 1 to 4 carbon atoms, a mono- or di(hydroxyalkyl)amino group having 2 to 4 carbon atoms, such as, for example, dimethylamine, ethylamine or hydroxyethylamine, a mono- to tetravalent alkenyl group having 2 to 4 carbon atoms, such as, for example, ethenyl, 1-methylethenyl, 3-butene-1,3-diyl and 2-propene-1,2-diyl, carboxyalkyl or carboxyalkenyl groups, such as 3-carboxy-2-propenyl groups, alkoxycarbonylalkyl or alkoxycarbonylalkenyl groups having 1 to 4 carbon atoms, such as, for example, 3-methoxycarbonyl-2-propenyl groups,
R¹ is hydrogen, an alkyl group or a hydroxyalkyl group having 1 to 5 carbon atoms (such as, for example, methyl, ethyl, n-propyl, n-butyl, sec-butyl, tert-butyl or pentyl, 2-hydroxyethyl, 3-hydroxypropyl, 2-hydroxypropyl, 4-hydroxybutyl, 3-hydroxybutyl or 2-hydroxy-2-methylpropyl) and
n is 1 or 2, m is 2-n and q is a number from 0 to 3,
X is a radical of the formula 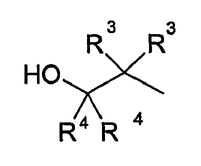
in which R³ and R⁴ are identical or different and each radical, independently of one another, is hydrogen or straight-chain or branched alkyl having 1 to 5 carbon atoms or R³ and R⁴, together with the carbon atom to which they are bonded, form a cycloaliphatic ring (such as, for example, cyclopentyl or cyclohexyl), or are a hydroxyalkyl group having 1 to 5 carbon atoms (hydroxymethyl and 1-hydroxyethyl).

Particularly preferably, n is 2 and m is 0. A is preferably C₂-C₁₀-alkylene and particularly preferably C₂-C₈-alkylene, which may be linear or branched.

The composition according to the invention particularly preferably comprises a compound of the formula II, 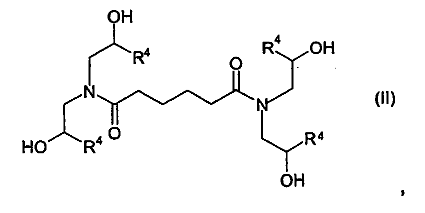 in which R⁴ is as defined above and is preferably hydrogen or methyl. These compounds are solid at 120°C and become liquid at temperatures above 150°C.

In a further preferred embodiment, the compound of the formula I is a liquid bi- to tetrafunctional compound having a viscosity of 1 000-10 000 mPa·s at 25°C. Primid V 40-30 is particularly preferred.

The at least bifunctional, acidic prepolymer (A) curable by the action of heat is preferably selected from the group consisting of the acrylate resins, polyurethane resins, the cyanate ester resins, the benzoxazine resins, the polyphenylene resins, the polyimide resins and mixtures thereof.

The composition according to the invention preferably comprises from 3 to 50% by weight, particularly preferably from 5 to 35% by weight and in particular from 8 to 20% by weight of the compounds of the formula I and from 97 to 50% by weight, particularly preferably from 95 to 65% by weight and in particular from 92 to 80% by weight, of a curable, at least bifunctional acidic prepolymer (A), based on the composition comprising the two components.

In a particularly preferred embodiment, the composition according to the invention comprises an acidic prepolymer (A) which is both photocurable and heat-curable. This is preferably selected from the group consisting of:
a photocurable and heat-curable acidic prepolymer having an acid value of from 40 to 250 mg KOH/g, obtainable by reacting a polymer or copolymer compriseing unsaturated carboxyl groups with a compound which comprises an alicyclic epoxy group;
a photocurable and heat-curable acidic prepolymer, obtainable by complete esterification of the epoxy groups of an epoxy resin with an α,β-unsaturated carboxylic acid and subsequent reaction of the product thus obtained with a saturated or unsaturated carboxylic anhydride;
a photocurable and heat-curable acidic prepolymer, obtainable by reaction of a bisphenol A type epoxy compound with epichlorohydrin with formation of a post-glycidylated epoxy compound, subsequent complete esterification of the epoxy groups of the post-glycidylated epoxy compound with an α,β-unsaturated carboxylic acid and subsequent reaction of the product obtained with a saturated or unsaturated carboxylic anhydride, and
a photocurable and heat-curable acidic prepolymer, obtainable by reaction of a bisphenol A type epoxy compound with epichlorohydrin with formation of a post-glycidylated epoxy compound, mixing of the post-glycidylated epoxy compound with a novolak epoxy compound, complete esterification of the mixture with an α,β-unsaturated carboxylic acid and subsequent reaction of the product thus obtained with a saturated or unsaturated carboxylic anhydride.

These photocurable and heat-curable acidic prepolymers (A) may be present alone or as mixtures in the composition according to the invention.

The abovementioned unsaturated monobasic acid copolymer resins are obtainable by copolymerizing an ethylenically unsaturated carboxylic acid, such as, for example, (meth)acrylic acid, 2-carboxyethyl (meth)acrylate, 2-carboxypropyl (meth)acrylate, maleic anhydride and the like, with at least one monomer selected from the group consisting of (meth)acrylic esters, such as methyl (meth)acrylate, ethyl (meth)acrylate, propyl (meth)acrylate, butyl (meth)acrylate, 2-ethylhexyl (meth)acrylate, stearyl (meth)acrylate, hydroxyethyl (meth)acrylate, hydroxypropyl (meth)acrylate and the like; vinylaromatic compounds, such as styrene, α-methylstyrene, vinyltoluene, p-chlorostyrene and the like; amide-like unsaturated compounds, such as (meth)acrylamide, diacetoneacrylamide, N-methylolacrylamide, N-butoxymethylacrylamide and the like; polyolefin compounds, butadiene, isoprene, chloroprene and the like; and other compounds, such as (meth)acrylonitrile, methyl isopropenyl ketone, vinyl acetate, Beoba monomer (product of Shell Chemical), vinyl propionate, vinyl pivalate and the like. The acid value of the unsaturated copolymer is preferably in the range from 30 to 260 mg KOH/g.

The unsaturated compound compriseing an alicyclic epoxy group is a compound having an unsaturated group capable of free radical polymerization and an alicyclic epoxy group in one molecule. This unsaturated compound comprising an alicyclic epoxy group is obtainable by copolymerization of an unsaturated monomer as a main monomer component comprising an alicyclic epoxy group with at least one above-described monomer of the unsaturated monobasic acid copolymer resins, such as a (meth)acrylic ester, vinylaromatic compounds and the like.

For the preparation of the radiation-curable and photocurable acidic prepolymer from an unsaturated resin compriseing an alicyclic epoxy group and an unsaturated compound compriseing an acid group, a solution of an unsaturated resin compriseing an alicyclic epoxy group in an inert organic solvent is reacted with the unsaturated compound compriseing the acid group for from 1 to 7 hours at a temperature of from 20 to 110°C.

The radiation-curable and photocurable acid-compriseing prepolymer thus obtained has from 0.2 to 4.0, preferably from 0.7 to 3.5, double bonds per 1 000 molecular weight units and an average molecular weight of from 1 000 to 100 000 g/mol, preferably from 3 000 to 20 000 g/mol.

The following general formula (III) shows a photocurable and heat-curable acidic prepolymer (A) 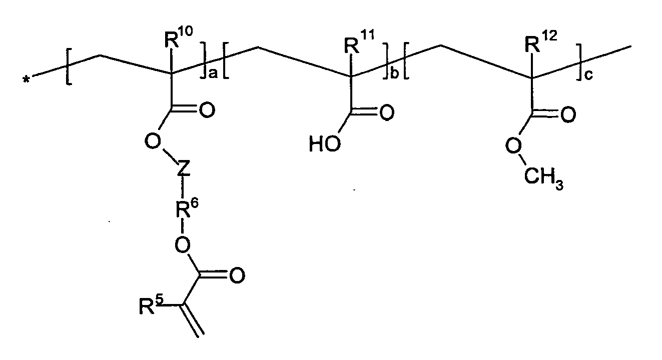 which is particularly preferably present in the composition according to the invention and in which
R⁵ is hydrogen or a methyl group,
R⁶ is a divalent aliphatic saturated hydrocarbon group having 1 to 14 carbon atoms and in particular a linear or branched alkylene chain, such as methylene, ethylene, propylene, tetramethylene, ethylethylene, pentamethylene or hexamethylene, or a phenylene,
R¹⁰, R¹¹ and R¹², independently of one another, are hydrogen or a methyl group,
Z is a direct bond or a divalent cycloalkane having 5 to 10 carbon atoms,
a and b are numbers from 1 to 10 and c is a number from 0 to 10.

In the resin composition according to the invention, the ratio a:b:c is preferably 5:3:2. The acid value is preferably in the range of 60-90 mg KOH/g, since the composition is most stable and has the best properties in this range. The molecular weight is preferably in the range from 400-6 000 g/mol.

For the preparation of an acidic prepolymer which is curable by the action of heat and photocurable from an acrylic resin compriseing an acid group and an unsaturated compound compriseing an alicyclic epoxy group, for example, a solution of an acrylic resin compriseing an acid group in an inert organic solvent, such as alcohol, ester, aromatic hydrocarbons and the like, can be reacted with the unsaturated compound compriseing the alicyclic epoxy group at a temperature of from 20 to 120°C for from 1 to 5 hours.

The acidic prepolymer preferably comprises from 0.2 to 4.0, particularly preferably from 0.7 to 3.7, double bonds per 100 g/mol molecular weight. If the number of double bonds is in this range, good curing is achieved and the adhesive properties with respect to the substrate and the resistance to water are ideal.

The photocurable and heat-curable acidic prepolymers preferably have an average molecular weight from 1 000 to 100 000 g/mol, particularly preferably from 3 000 to 70 000 g/mol. With these molecular weights, the photocurable acid-compriseing prepolymer can be readily used owing to its viscosity.

The acid value of the photocurable and heat-curable acidic prepolymer is preferably up to 120 mg KOH/g, since the composition according to the invention then has good water resistance.

Alternatively, photocurable and heat-curable acidic prepolymer which is obtainable by reacting a vinyl resin compriseing an alicyclic epoxy group and an unsaturated compound compriseing an acid group may also be present in the composition according to the invention.

The abovementioned photocurable and heat-curable resins may be present alone or in combination in the composition according to the invention.

In a further preferred embodiment, the composition according to the invention comprises, as acidic prepolymer (A) which is both curable by the action of heat and radiation-curable, the prepolymer of the formula IV, which has been reacted with a dicarboxylic anhydride, for example phthalic anhydride, 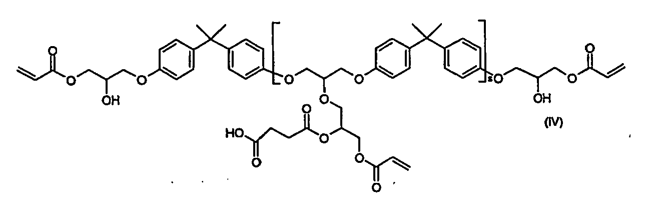 in which s is a number from 1 to 20.

The formulation according to the invention may also comprise a prepolymer (B) which is only photocurable.

The composition according to the invention has excellent photosensitivity. The compound of the formula I does not adversely influence the development process, and no gelling occurs. Consequently, the composition according to the invention can be rapidly developed. In the subsequent thermal step, the compound of the formula I is melted, unless it is already present in the liquid state, and is reacted with the photocurable and heat-curable acid-compriseing prepolymer. This gives a layer, such as, for example, a solder resist mask for circuit boards, which meets the abovementioned requirements.

In a further preferred embodiment, the formulation according to the invention additionally comprises a telechelic elastomer and/or a particulate material having a core and a shell, the core comprising a silicone resin and the shell an acrylate resin. The telechelic elastomer has at least one primary hydroxyl group at one end of the molecule and has at least one epoxidized polyisoprene group at the other end of the molecule. A particularly preferred telechelic elastomer is the Kraton Liquid EKP-207 polymer. A particularly preferred particulate material having a core and a shell is Silicone Core Shell (Wacker AG, Germany). A layer produced using such a formulation is extremely resistant to rapid temperature changes.

A diluent, which is a photopolymerizable vinyl monomer and/or an organic solvent, is preferably added to the composition according to the invention.

The photopolymerizable vinyl monomers are preferably selected from the group consisting of hydroxyalkyl acrylates, such as 2-hydroxyethyl acrylate, 2-hydroxybutyl acrylate and the like; mono- or diacrylates of glycol, such as ethylene glycol, methoxytetraethylene glycol, polyethylene glycol, propylene glycol and the like, ethylene glycol diacrylate, diethylene glycol diacrylate and the like; acrylamides, such as N,N-dimethylacrylamide, N-methylolacrylamide, methylenebisacrylamide, diethylenetriaminetriacrylamide, bisacrylamidopropoxyethane, bismethacrylamidoethyl methacrylate, N-[(β-hydroxyethyloxy)ethyl]acrylamide and the like; aminoalkyl acrylates, such as N,N-dimethylaminoethyl acrylate and the like; polyvalent acrylates of polyols, such as hexanetriol, trimethylolpropane, pentaerythritol, dipentaerythritol, trihydroxyethyl isocyanurate and the like, and ethylene oxide adducts thereof or propylene oxide adducts; phenoxyacrylates, bisphenol A diacrylate and acrylates of ethylene oxide adducts and propylene oxide adducts of these phenols; acrylates of glycidyl ethers, such as glyceryl diglycidyl ether, trimethylolpropane triglycidyl ether, triglycidyl isocyanurate and the like; melamine acrylate; and methacrylates of the abovementioned acrylates; etc.

The organic solvents are preferably selected from the group consisting of the ketones, such as methyl ethyl ketone, cyclohexanone and the like; aromatic hydrocarbons, such as toluene, xylene, tetramethylbenzene and the like; glycol ethers, such as methylcellosolve, butylcellosolve, methylcarbitol, butylcarbitol, propylene glycol monomethyl ether, dipropylene glycol monoethyl ether, triethylene glycol monoethyl ether and the like; esters, such as ethyl acetate, butyl acetate, acetates of the abovementioned glycol ethers and the like; alcohols, such as ethanol, propanol, ethylene glycol, propylene glycol and the like; aliphatic hydrocarbons, such as octane, decane and the like; and petroleum solvents, such as petroleum ether, petroleum naphtha, hydrogenated petroleum naphtha, naphtha solvents and the like. These organic solvents serve for reducing the viscosity of the composition according to the invention, which leads to an improvement in its application properties.

The diluent may be used alone or as a mixture of a plurality of diluents. The composition according to the invention expediently comprises up to 15% by weight of the diluent, based on the composition according to the invention.

By adding the photopolymerizable vinyl monomer as a diluent, not only is the viscosity reduced but at the same time the photopolymerization rate is increased.

The photopolymerization initiator may also be added to the composition according to the invention if the composition is cured by UV exposure. Typical examples of photopolymerization initiators are benzoin and benzoin alkyl ethers, such as benzoin, benzil, benzoin methyl ether, benzoin ethyl ether, benzoin n-propyl ether, benzoin n-butyl ether, benzoin isopropyl ether and the like; benzophenones, such as benzophenone, p-methylbenzophenone, Michler's ketone, methylbenzophenone, 4,4'-dichlorobenzophenone, 4,4-bisdiethylaminobenzophenone and the like; acetophenones, such as acetophenone, 2,2-dimethoxy-2-phenylacetophenone, 2,2-diethoxy-2-phenylacetophenone, 1,1-dichloroacetophenone, 1-hydroxycyclohexyl phenyl ketone, 2-methyl[4-(methylthio)phenyl]-2-morpholino-1 -propanone, N,N-dimethylaminoacetophenone and the like; thioxanthone and xanthones, such as 2,4-dimethylthioxanthone, 2,4-diethylthioxanthone, 2-chlorothioxanthone, 2,4-diisopropylthioxanthone and the like; anthraquinones, such as anthraquinone, chloroanthraquinone, 2-methylanthraquinone, 2-ethylanthraquinone, 2-tert-butylanthraquinone, 1-chloroanthraquinone, 2-amylanthraquinone, 2-aminoanthraquinone and the like; ketals, such as acetophenone dimethyl ketal, benzyl dimethyl ketal and the like; benzoic esters, such as ethyl 4-dimethylaminobenzoate, 2-(dimethylamino)ethyl benzoate, ethyl-p-dimethylaminobenzoate and the like; phenyl disulphides, 2-nitrofluorene, butyloin, anisoin ethyl ether, azobisisobutyronitriles, tetramethylthiuram disulphide and the like. These compounds may be present individually or in combination in the composition according to the invention.

The photopolymerization initiator is preferably present in an amount of from 0.1 to 10 percent by weight, based on the composition according to the invention.

The composition according to the invention may also comprise inorganic and/or organic fillers in order to improve the adhesion properties or the hardness of the layer. The inorganic fillers are preferably selected from the group consisting of barium sulphate, barium titanate, pulverized silica, finely pulverized silica, amorphous silica, talc, chalk, magnesium carbonate, calcium carbonate, alumina, aluminium hydroxide, mica powder and the like. The composition according to the invention comprises up to 40 percent by weight, preferably 5-30 percent by weight, of inorganic fillers, based on the composition according to the invention.

The composition according to the invention may also comprise additives, such as colorants, thickeners, antifoams, levelling agents, thermal polymerization inhibitors or antioxidants. Possible colorants are phthalocyanine blue, phthalocyanine green, iodine green, disazo yellow, crystal violet, titanium oxide, carbon black, naphthalene black and the like. Possible thermal polymerization inhibitors are hydroquinone, hydroquinone monomethyl ether, tert-butylcatechol, pyrogallol, phenothiazine and the like. Suitable thickeners are, for example, orbene, bentone, montmorillonite and the like. Suitable antifoams are, for example, fluorosilicone-like, fluoride-like or polymer-like antifoams.

In the production of a circuit board comprising a layer, such as, for example, a solder resist mask, the printed circuit board is first coated with the composition according to the invention and then dried for evaporation of the diluent with formation of a layer (from 60 to 90°C for from 15 to 60 minutes). This layer is then selectively exposed, preferably with the use of a patterned negative mask. After the exposure, the layer is developed with a developing liquid in order to remove the unexposed parts of the layer. Finally, the layer is postcured by heating, a solder resist mask serving as protective layer being obtained on the circuit board. The heat treatment for the postcuring can be carried out at from 100 to 160°C, preferably from 130 to 180°C.

Electronic components comprising a layer produced using the formulation according to the invention are stable for a long time. One-layer or multilayer circuit boards comprising at least one layer produced using the composition according to the invention are particularly preferred.

The formulation according to the invention is preferably sold in a set comprising two compriseers A and B. Those components which react together are separated, so that the compriseer A comprises the compound of the formula I and the compriseer B comprises the remaining components, such as the acid-compriseing prepolymer curable under the action of heat and optionally the photocurable acid-compriseing prepolymer, the photopolymerization initiator and/or fillers.

The following examples explain the invention in more detail. Parts are parts by weight.

### Example 1: A photocurable acid-compriseing prepolymer

A mixture consisting of 20 parts of methyl methacrylate, 20 parts of styrene, 25 parts of methyl acrylate, 15 parts of 2-hydroxyethyl methacrylate, 20 parts of acrylic acid and 5 parts of azobisisobutyronitrile is added dropwise to 60 parts of butylcellosolve, which is initially introduced into a reactor, in a nitrogen atmosphere over a period of 3 hours. After the addition, the resulting mixture reacts for a further hour. Thereafter, a mixture consisting of 1 part of azobisdimethylvaleronitrile and 7 parts of butylcellosolve is added over a period of one hour and the resulting mixture in turn is reacted for 5 hours. The resin thus formed has a high acid value (150). After addition of 25 parts of an unsaturated resin having an alicyclic epoxy group and 0.06 part of hydroquinone, the resulting mixture is reacted at 80°C for 5 hours with addition of air. The photocurable prepolymer thus obtained has an acid value of 60 and an average molecular weight of 10 000 g/mol.

### Example 2:

The glycidation of a side chain of an epoxy resin can be carried out by known methods as described, for example, in JP-A-8-134390. 100 parts of a bisphenol A type epoxy resin (GT7004, produced by Vantico; softening point 101°C, epoxide equivalent = 730, average molecular weight 1 460, n = 3.9 on average) are dissolved in a mixture of 171 parts of epichlorohydrin and 116 parts of dimethyl sulphoxide. 15 parts of 98.5% NaOH are added dropwise at 70°C to this solution over a period of 100 minutes. After the addition, the reaction is carried out in a period of 3 hours at 70°C. The main part of the excess unreacted epichlorohydrin and of the dimethyl sulphoxide is then distilled off under reduced pressure. The reaction product contaminated with dimethyl sulphoxide and the salt formed as a byproduct are dissolved in 187.5 parts of methyl isobutyl ketone. 1.8 parts of 30% NaOH are added to this solution and reaction is effected at 70°C for 1 hour. After the reaction, the reaction mixture is washed with 50 parts of water. After the organic phase has been separated from the aqueous phase, the isobutyl ketone is distilled off from the organic phase in order to obtain 81.2 parts of an epoxy resin having an epoxide equivalent of 305 and a softening point of 83°C. In the epoxy resin, 3.5 mol out of 3.9 mol of the alcoholic OH groups have been epoxidized.

### Example 3:

In a three-necked flask having a stirrer and a condenser, 1.09 parts of a cresol novolak type epoxy resin having an epoxide equivalent of 215 (JDCN-702, produced by Tohto Kasei AG) are heated and are melted at 90-100°C while stirring. 390 parts of acrylic acid, 1 part of hydroquinone and 2 parts of benzyldimethylamine are then added. The mixture is heated to 110-115°C and reacted for 12 hours while stirring. The solution thus obtained is then cooled to room temperature. The resulting product of a novolak type epoxy compound in which the acrylic acid is completely esterified has an acid value of 3 mg KOH/g. 450 parts of this product are introduced, together with 125 parts of ethylcarbitol acetate and 125 parts of Solvesso #150, into a reactor and stirred at 70-80°C so that a homogeneous solution forms. One hydroxyl equivalent of the resulting solution is then reacted with 0.5 mol of tetrahydrophthalic anhydride. A solution of the acid anhydride adduct having an acid value of 58 mg KOH/g is obtained.

The compositions are prepared according to the ratios shown in table 1. The numerical values are stated in % by weight. After an initial brief mixing of the ingredients, each formulation is kneaded twice in a three-roll mill. The size distribution of the particles in each formulation is measured using a grindometer (produced by Erichsen Co.). The particles thus obtained are smaller than 16 µm.

The total surface area of a circuit board is coated with the composition and dried in an air circulation oven at 80°C for 20 minutes. After drying, the layer thus obtained is exposed to light, developed and finally cured by heat in order to obtain a solder resist pattern.

### Resistance to hot/cold cycles

Each formulation is exposed through a photomask to ultraviolet light at a wavelength of 365 nm and in a dose of 200-400 mJ/cm² (measured using an integral actinometer produced by Oak Seisakusho AG). The development is carried out with a weakly aqueous alkaline developing solution for 60 seconds under a spray pressure of 2 kg/cm². The developed test board is placed in an apparatus for temperature change. The temperature is changed alternately from -55°C to 125°C, the temperature being maintained in each case for 15 minutes. The term cycle is used when the temperature change from -55°C to 125°C (or back) is complete. The formation of new tears is checked after 50 cycles. If a tear is found, the test is terminated.

### Photosensitivity test

Each test board is exposed to ultraviolet light at a wavelength of 365 nm and in a dose of 300 mJ/cm², 400 mJ/cm² and 450 mJ/cm² (measured using an integral actinometer (Oak Seisakosho AG)). After the development with a weakly alkaline aqueous solution for 60 seconds under a gentle spray pressure of 2 kg/cm², the state of the film thus formed is checked visually and assessed according to the following criteria:
Q: no change observable
R: slight change observable
S: slight change of surface observable
T: the film is tom off.

### Development test

The test board is prepared by exposure of the coated test board through a photomask to ultraviolet light having a wavelength of 365 nm and in a dose of 200-400 mJ/cm² (measured using an integral actinometer (Oak Seisakosho AG)). In the comparative examples, exposure is effected using a dose of 200-750 mJ/cm². The development is carried out in a weakly alkaline aqueous solution under a spray pressure of 2 kg/cm² for a period of 20, 40 or 60 seconds. After the development, the removal of the unexposed layer is checked visually and assessed according to the following criteria:
Q: complete development was achieved
R: a thin layer of undeveloped material remains on the surface
S: undeveloped material is distributed over the entire test board
T: scarcely any development was achieved.

### Adhesion test (according to DIN 53151)

The test board is exposed through a photomask to ultraviolet light at a wavelength of 365 nm and in a dose of 200-400 mJ/cm² (measured using an integral actinometer (Oak Seisakosho AG)). In the comparative examples, exposure is effected at a dose of from 200 to 750 mJ/cm². The development is carried out with a weakly alkaline aqueous solution under a spray pressure of 2 kg/cm² for a period of 60 seconds. The developed test boards are postcured under various conditions. Each test board thus obtained is subjected to a crosshatch test and subjected to a peel test with a cellophane adhesive tape. The test boards are then checked visually and the result is assessed according to the following criteria:
Q: 100/100 no peeling observable
R: 100/100 slight peeling in the crosshatch lines
S: 50/100 to 90/100 moderate adhesion
T: 0/100 to 50/100 weak adhesion.

### Pencil hardness test

The same test board used in the adhesion test is subjected to a hardness test by the method of JISK5400 under a load of 1 kg.

### Acid resistance test

The same test board which is used in the adhesion test is placed in a 10% (V/V) aqueous sulphuric acid solution at 20°C for 30 minutes. The acid resistance is assessed on the basis of the peeling and of the adhesion:
Q: no change observable
R: slight change observable
S: considerable change observable.
T: swelling of the film or falling off of the film as a result of swelling observable.

### Alkali resistance test

The test and the assessment are carried out analogously to the acid resistance test, except that the aqueous sulphuric acid solution is replaced by a 10% by weight aqueous NaOH solution.

### Solvent resistance

The test and the assessment are carried out analogously to the acid resistance test, except that the aqueous sulphuric acid is replaced by acetone.

### Metallization stability test (Ni/Au stability)

The plating solution used is Aotolonex Cl (plating solution produced by Cellex Corp. USA). The test board used is the same as that used in the adhesion test. This is metallized for 9 minutes at a liquid temperature of 30°C and a current density of 1 A/dm², in order to apply gold in a thickness of 1.5 µm. The condition of the film is assessed under the same criteria as for the acid resistance test.

### Solder resistance test

According to the test methods described in JISC6481, the test board used in the adhesion test is immersed for 10 seconds in a solder bath at 260°C (once on one side and 3 times on the other side). The condition of the film is then checked according to the same criteria as in the acid resistance test.

### Sensitivity

A film of a sample is exposed to ultraviolet light at a wavelength of 365 nm and in a dose of 200-400 mJ/cm² (measured using an integral actinometer (Oak Seisakosho AG)) and then developed in a weakly alkaline aqueous solution under a spray pressure of 2 kg/cm² for 60 seconds. After the development, the film is checked visually. The photomask used is a Step-Tablet, produced by Stoffer Co. In the case of the test boards thus obtained, the tack/dryness after drying, the photosensitivity, the developability (condition of the film after development), flexibility after final curing, cold/hot stability, adhesion, hardness of the film, acid resistance, alkali resistance, solvent resistance, metallization stability, solder heat resistance, flux resistance, insulation resistance, insulation resistance under humid conditions, resolution, water absorption and sensitivity are assessed. The results are summarized in table 2. The test boards of the comparative examples are exposed at 750 mJ/cm² since the surface of the resist is damaged and the characteristic properties cannot be compared with those exposed at 300 mJ/cm².

### Stability of the formulation after mixing

The ingredients of the composition are combined. After initial brief mixing of the ingredients, each formulation is kneaded twice in a three-roll mill. The formulation is stored at 40°C. The stability of the formulation is checked daily.

### Stability after coating

The formulation is applied as described above to the surface of a circuit board. The coated circuit board is not further processed directly but is stored and further processed later on.

**Table 1: Formulations**

| Example No. | 1 | 2 | 3 | 4 | 5 | 6 | 7 | 8 |
|---|---|---|---|---|---|---|---|---|
| Resin according to example 1 | 40.6 | | | 24.13 | | 44.04 | | |
| Resin according to example 2 | | 40.88 | | | 43.77 | | 44.26 | |
| Resin according to example 3 | | | 39.34 | 14.67 | | | | 39.78 |
| Irgacure^{®} 907 | 6.83 | 6.84 | 6.90 | 7.02 | 6.18 | 6.22 | 6.25 | 8.93 |
| Quantacure^{®} ITX | 0.97 | 0.97 | 0.39 | 0.39 | 1.05 | 1.06 | | 0.40 |
| Sartomer^{®} 351 | | | 2.93 | 3.04 | | | | 2.96 |
| Sartomer^{®} 399 | 9.95 | 10.03 | 8.16 | 8.46 | 7.15 | 6.44 | 10.85 | 8.25 |
| Barium sulphate | 24.38 | 23.12 | 25.62 | 25.26 | 24.97 | 33.36 | 25.26 | 25.89 |
| Flowlen AC 303 | 0.31 | 0.31 | - | - | 0.33 | 0.34 | 0.34 | |
| TSA 750 S^{®} | - | - | 2.02 | 1.99 | | | | |
| Disperbyl^{®} 170 | 0.08 | 0.08 | 0.07 | 0.07 | 0.09 | 0.09 | 0.09 | 0.09 |
| Phthalocyanine green | 0.44 | 0.44 | 0.54 | 0.56 | 0.48 | 0.48 | 0.48 | 0.54 |
| Primid XL 552 | 6.81 | 6.04 | 5.39 | 6.06 | 6.47 | | | |
| Primid^{®} V 40-30 | | | | | | 5.90 | 5.42 | 4.35 |
| Particulate material having a core and shell (silicone core shell) | | | | | 5.02 | | | |
| Kraton L 207 | | | | | 1.50 | | | |

**Table 2: Comparison of the properties**

| Example No. | 1 | 2 | 3 | 4 | 5 | 6 | 7 | 8 |
|---|---|---|---|---|---|---|---|---|
| Developability | Q | Q | Q | Q | Q | Q | R | Q |
| Photosensitivity | Q | Q | Q | Q | Q | Q | Q | Q |
| Adhesion in crosshatch test | 0 | 0 | 0 | 0 | 0 | 4 | 0 | 4 |
| Pencil hardness | 6H | 6H | 6H | 6H | 4H | 5H | 7H | 6H |
| Punching behaviour | moderate | moderate | good | moderate | good | poor | moderate | poor |
| Acid resistance | Q | Q | Q | Q | Q | Q | Q | Q |
| Alkali resistance | Q | Q | Q | Q | Q | T | S | S |
| Solvent resistance | R | R | R | R | R | S | S | S |
| Solder resistance | Q | Q | Q | Q | Q | Q | Q | Q |
| Ni/Au stability | R | Q | Q | R | Q | T | T | T |
| Resistance to hot/cold cycles -55°C / 15 min + 165°C / 15 min | < 50 cycles | < 50 cycles | < 50 cycles | < 50 cycles | >700 cycles | < 50 cycles | < 50 cycles | < 50 cycles |
| Hold time after coating | >7d | > 7d | >7d | >7d | >7d | >7d | > 1d | > 7d |
| Stability at 40°C | >12W | >12W | >12W | >12W | >12W | >12W | <1d | >12W |

## Claims

1. A composition comprising an at least bifunctional acidic prepolymer (A) curable under the action of heat, which additionally comprises a compound of the formula I 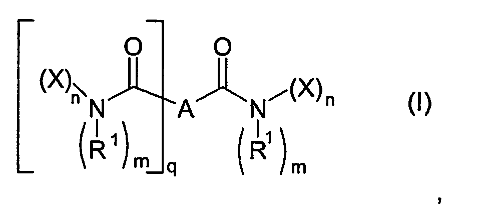 in which
A is a mono- to tetravalent, saturated or unsaturated alkyl group having 1 to 60 carbon atoms, a mono- to tetravalent aryl group, a mono- or dialkylamino group having 1 to 4 carbon atoms, an alkenylene group having 2 to 4 carbon atoms, a carboxyalkylene group or an alkoxycarbonylalkylene group having 1 to 4 carbon atoms in the alkylene group,
n is 1 or 2,
m is 2-n,
q is a number from 0 to 3,
R¹ is hydrogen or an alkyl group having 1 to 5 carbon atoms or a hydroxyalkyl group having 1 to 5 carbon atoms and
X is a radical of the formula 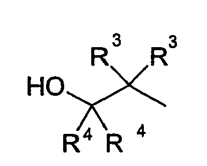
in which R³ and R⁴ are identical or different and, independently of one another, are hydrogen, a straight-chain or branched alkyl group or hydroxyalkyl group having 1 to 5 carbon atoms, or R³ and R⁴, together with the carbon atom to which they are bonded, form a cycloaliphatic ring.

2. A composition according to claim 1, comprising, as the compound of the formula I, the compound of the formula II 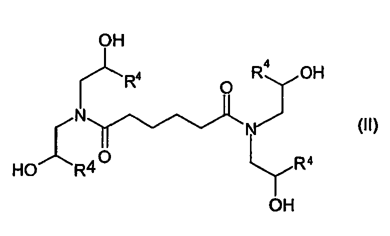 in which R⁴ in each case is hydrogen or in each case is a methyl group.

3. A composition according to any one of the preceding claims, wherein the acid-comprising prepolymer (A) is both heat-curable and photocurable.

4. A composition according to any one of the preceding claims, which additionally comprises a photocurable prepolymer (B).

5. A composition according to any one of the preceding claims, which additionally comprises a photopolymerization initiator.

6. A composition according to any one of the preceding claims, which additionally comprises fillers.

7. A composition according to claim 2, wherein, in the compound of the formula II, R⁴ is in each case hydrogen.

8. A composition according to claim 2, wherein, in the compound of the formula II, R⁴ is in each case a methyl group.

9. A composition according to any one of the preceding claims, wherein the acidic prepolymer (A) is a prepolymer of the formula III 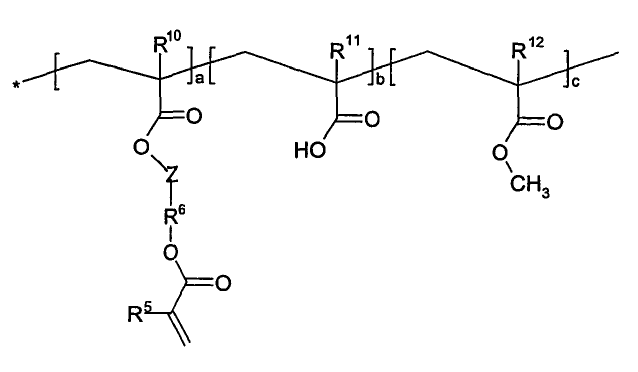 in which
R⁵ is hydrogen or a methyl group,
R⁶ is a linear or branched alkylene chain having 1 to 14 carbon atoms,
R¹⁰, R¹¹ and R¹², independently of one another, are hydrogen or a methyl group,
Z is a direct bond or cycloalkylene having 5 to 10 carbon atoms,
a and b are a number from 1 to 10 and c is a number from 0 to 10.

10. A composition according to any one of the preceding claims, wherein the acidic prepolymer (A) is one which is obtainable by reacting a prepolymer of the formula IV with a dicarboxylic anhydride 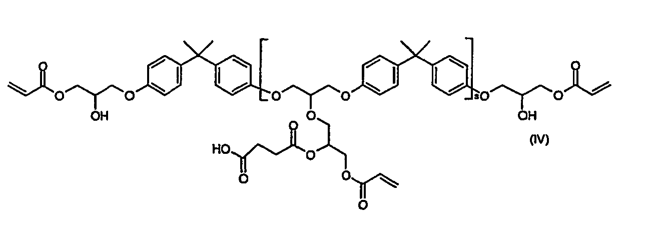 in which s is a number from 1 to 20 and
the acid-compriseing prepolymer (A) is curable both by the action of heat and by exposure to light.

11. A composition according to any one of the preceding claims, which additionally comprises a telechelic elastomer and/or a particulate material having a core and a shell, the core comprising a silicone resin and the shell an acrylate resin.

12. A printed circuit which has at least one layer, produced from a composition according to any one of the preceding claims.

13. A printed circuit according to claim 12, which is a circuit board.

14. A packaging unit comprising two compounds A and B, comprising the composition according to any one of claims 1 to 11, wherein the compound A comprises the compound of the formula I and
the compound B comprises the at least bifunctional acidic prepolymer (A) curable under the action of heat and optionally the photocurable prepolymer (B), the photopolymerization initiator and/or fillers.

15. Use of the composition according to any one of claims 1-11 as photoresist in the production of circuit boards.

## Patentansprüche

1. Eine Zusammensetzung, die ein mindestens bifunktionales saures Prepolymer (A) umfasst, welches unter Wärmeeinfluss härtbar ist, die zusätzlich eine Verbindung der Formel I 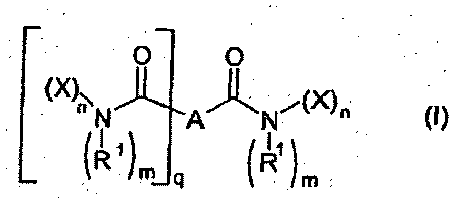 umfasst, bei der
A eine ein- oder vierwertige, gesättigte oder ungesättigte Alkylgruppe mit 1 bis 60 Kohlenstoffatomen, eine ein- oder vierwertige Arylgruppe, eine Mono- oder Dialkylaminogruppe mit 1 bis 4 Kohlenstoffatomen, eine Alkenylengruppe mit 2 bis 4 Kohlenstoffatomen, eine Carboxyalkylengruppe oder eine Alkoxycarbonylalkylengruppe mit 1 bis 4 Kohlenstoffatomen in der Alkylengruppe ist;
n 1 oder 2 ist;
m 2-n ist;
q eine Zahl von 0 bis 3 ist;
R¹ Wasserstoff oder eine Alkylgruppe mit 1 bis 5 Kohlenstoffatomen oder eine Hydroxyalkylgruppe mit 1 bis 5 Kohlenstoffatomen ist; und
X ein Rest der Formel 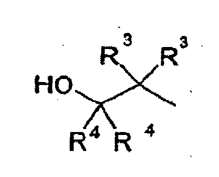
ist, bei dem R³ und R⁴ identisch oder verschieden sind und unabhängig voneinander Wasserstoff, eine geradkettige oder verzweigte Alkylgruppe oder Hydroxyalkylgruppe mit 1 bis 5 Kohlenstoffatomen sind, oder R³ und R⁴ zusammen mit dem Kohlenstoffatom an das sie gebunden sind einen cycloaliphatischen Ring bilden.

2. Eine Zusammensetzung gemäß Anspruch 1, die als die Verbindung nach Formel I die Verbindung nach Formel II 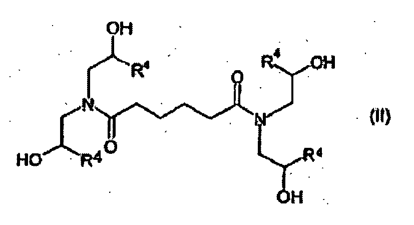 umfasst, bei der R⁴ jeweils Wasserstoff oder jeweils eine Methylgruppe ist.

3. Eine Zusammensetzung gemäß einem der vorangegangenen Ansprüche, wobei das Säure-umfassende Prepolymer (A) sowohl wärmehärtbar als auch photohärtbar ist.

4. Eine Zusammensetzung gemäß einem der vorangegangenen Ansprüche, die zusätzlich ein photohärtbares Prepolymer (B) umfasst.

5. Eine Zusammensetzung gemäß einem der vorangegangenen Ansprüche, die zusätzlich einen Photopolymerisationsinitiator umfasst.

6. Eine Zusammensetzung gemäß einem der vorangegangenen Ansprüche, die zusätzlich Füllstoffe umfasst.

7. Eine Zusammensetzung gemäß Anspruch 2, wobei bei der Verbindung nach Formel II R⁴ jeweils ein Wasserstoff ist.

8. Eine Zusammensetzung gemäß Anspruch 2, wobei bei der Verbindung nach Formel II R⁴ jeweils eine Methylgruppe ist.

9. Eine Zusammensetzung gemäß einem der vorangegangenen Ansprüche, wobei das saure Prepolymer (A) ein Prepolymer der Formel III 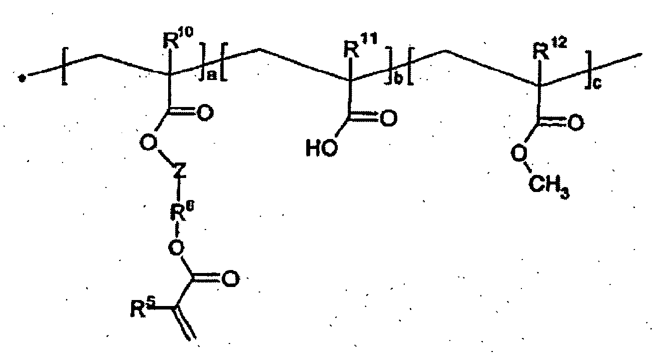 ist, bei dem
R⁵ Wasserstoff oder eine Methylgruppe ist;
R⁶ eine lineare oder verzweigte Alkylenkette mit 1 bis 14 Kohlenstoffatomen ist;
R¹⁰, R¹¹ und R¹² unabhängig voneinander Wasserstoff oder eine Methylgruppe sind;
Z eine direkte Bindung oder ein Cycloalkylen mit 5 bis 10 Kohlenstoffatomen ist;
a und b eine Zahl von 1 bis 10 sind und c eine Zahl von 0 bis 10 ist.

10. Eine Zusammensetzung gemäß einem der vorangegangenen Ansprüche, wobei das saure Prepolymer (A) eines ist, welches durch Umsetzen eines Prepolymers nach Formel IV 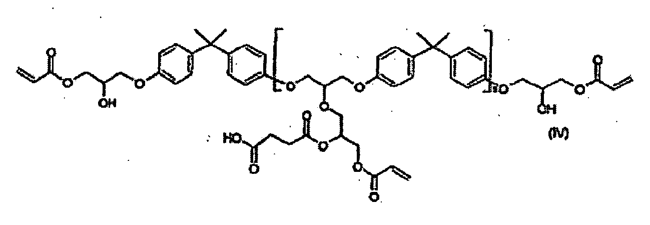 bei dem s eine Zahl von 1 bis 20 ist,
mit einem Dicarbonsäureanhydrid erhältlich ist und das Säure-umfassende Prepolymer (A) sowohl durch Wärmeeinfluss als auch durch Einwirken von Licht härtbar ist.

11. Eine Zusammensetzung gemäß einem der vorangegangenen Ansprüche, die zusätzlich ein telecheles Elastomer und/oder ein teilchenförmiges Material mit einem Kern und einer Schale umfasst, wobei der Kern ein Silikonharz und die Schale ein Acrylatharz umfasst.

12. Eine gedruckte Schaltung, die mindestens eine Schicht hat, welche aus einer Zusammensetzung gemäß einem der vorangegangenen Ansprüche hergestellt wird.

13. Eine gedruckte Schaltung gemäß Anspruch 12, die eine Leiterplatte ist.

14. Eine Verpackungseinheit, die zwei Verbindungen A und B umfasst, die die Zusammensetzung gemäß einem der Ansprüche 1 bis 11 umfassen, wobei die Verbindung A die Verbindung nach Formel I umfasst und die Verbindung B das mindestens bifunktionale Prepolymer (A), das unter Wärmeeinfluss härtbar ist, und optional das photohärtbare Prepolymer (B), den Photopolymerisationsinitiator und/oder Füllstoffe umfasst.

15. Verwendung der Zusammensetzung gemäß einem der Ansprüche 1-11 als Fotolack bei der Herstellung von Leiterplatten.

## Revendications

1. Composition comprenant un prépolymère acide au moins bifonctionnel (A) durcissable sous l'action de la chaleur, qui comprend en outre un composé de formule I : 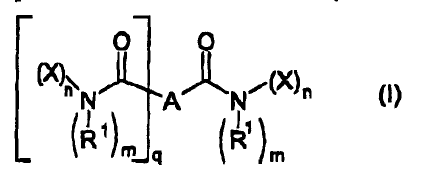 dans laquelle :
A est un groupe alkyle mono- à tétravalent, saturé ou insaturé ayant 1 à 60 atomes de carbone, un groupe aryle mono- à tétravalent, un groupe mono- ou dialkylamino ayant 1 à 4 atomes de carbone, un groupe alcénylène ayant 2 à 4 atomes de carbone, un groupe carboxyalkylène ou un groupe alcoxycarbonylalkylène ayant 1 à 4 atomes de carbone dans le groupe alkylène,
n vaut 1 ou 2,
m vaut 2 à n,
q est un nombre de 0 à 3,
R¹ représente un atome d'hydrogène ou un groupe alkyle ayant 1 à 5 atomes de carbone ou un groupe hydroxyalkyle ayant 1 à 5 atomes de carbone et
X représente un radical de formule : 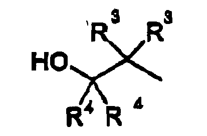
dans laquelle R³ et R⁴ sont identiques ou différents l'un de l'autre et, indépendamment l'un de l'autre, représentent un atome d'hydrogène, un groupe alkyle ou hydroxyalkyle à chaîne droite ou ramifiée ayant 1 à 5 atomes de carbone, ou R³ et R⁴, conjointement avec l'atome de carbone,auquel ils sont liés, forment un cycle cycloaliphatique.

2. Composition selon la revendication 1, comprenant, en tant que composé de formule I, le composé de formule II : 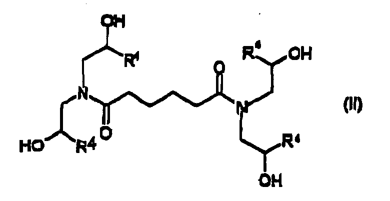 dans laquelle R⁴, dans chaque cas, représente un atome d'hydrogène ou, dans chaque cas, représente un groupe méthyle.

3. Composition selon l'une quelconque des revendications précédentes, dans laquelle le prépolymère comprenant un acide (A) est à la fois thermodurcissable et photodurcissable.

4. Composition selon l'une quelconque des revendications précédentes, qui comprend en outre un prépolymère photodurcissable (B).

5. Composition selon l'une quelconque des revendications précédentes, qui comprend en outre un amorceur de photopolymérisation.

6. Composition selon l'une quelconque des revendications précédentes, qui comprend en outre des charges.

7. Composition selon la revendication 2, dans laquelle, dans le composé de formule II, R⁴ représente, dans chaque cas, un atome d'hydrogène.

8. Composition selon la revendication 2, dans laquelle, dans le composé de formule II, R⁴ représente, dans chaque cas, un groupe méthyle.

9. Composition selon l'une quelconque des revendications précédentes, dans laquelle le prépolymère acide (A) est un prépolymère de formule III: 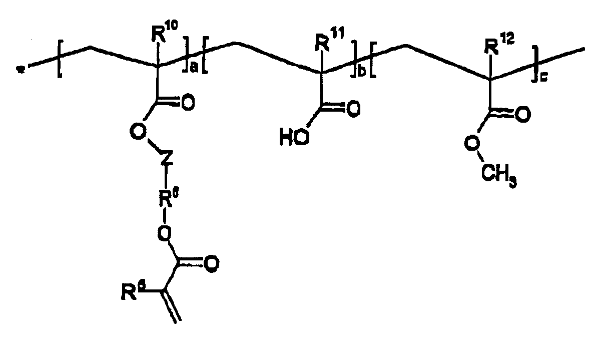 dans laquelle
R⁵ représente un atome d'hydrogène ou un groupe méthyle,
R⁶ représente une chaîne alkylène linéaire ou ramifiée ayant 1 à 14 atomes de carbone,
R¹⁰, R¹¹ et R¹², indépendamment les uns des autres, représentent un atome d'hydrogène ou un groupe méthyle,
Z représente une liaison directe ou un cycloalkylène ayant 5 à 10 atomes de carbone,
a et b représentent un nombre de 1 à 10 et c représente un nombre de 0 à 10.

10. Composition selon l'une quelconque des revendications précédentes, dans laquelle le prépolymère acide (A) est celui qui peut être obtenu en faisant réagir un prépolymère de formule IV avec un anhydride dicarboxylique : 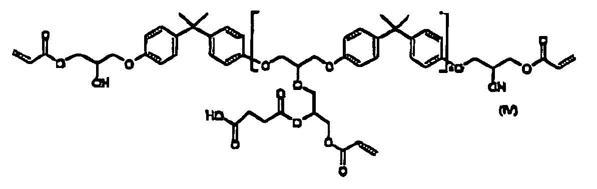 dans laquelle s représente un nombre de 1 à 20 et
le prépolymère comprenant un acide (A) est durcissable à la fois par l'action de chaleur et par exposition à la lumière.

11. Composition selon l'une quelconque des revendications précédentes, qui comprend en outre un élastomère téléchélique et/ou une matière particulaire ayant un coeur et une enveloppe, le coeur comprenant une résine de silicone et l'enveloppe, une résine acrylate.

12. Circuit imprimé qui possède au moins une couche, produite à partir d'une composition selon l'une quelconque des revendications précédentes.

13. Circuit imprimé selon la revendication 12, qui est une carte de circuit imprimé.

14. Unité de conditionnement comprenant deux composés A et B, comprenant la composition selon l'une quelconque des revendications 1 à 11, dans laquelle le composé A comprend le composé de formule I et
le composé B comprend le prépolymère acide au moins bifonctionnel (A) durcissable sous l'action de la chaleur et éventuellement le prépolymère photodurcissable (B), l'amorceur de photopolymérisation et/ou des charges.

15. Utilisation de la composition selon l'une quelconque des revendications 1 à 11 en tant que photorésist pour la production de cartes de circuit imprimé.
